# EUROPEAN PATENT APPLICATION

(11) **EP 4 227 537 A1**
(43) Date of publication of application: **16.08.2023**
(21) Application number: 21877528.6
(22) Date of filing: 01.10.2021
(51) Int. Cl.: F04D 19/04

(54) **VACUUM PUMP AND VACUUM EXHAUST SYSTEM WHICH USES SAME**

(30) Priority: 09.10.2020 JP 2020170939
(71) Applicant: Edwards Japan Limited, Yachiyo-shi, Chiba 276-8523 (JP)
(72) Inventor: SAKAGUCHI, Yoshiyuki, Yachiyo-shi Chiba 276-8523 (JP)
(74) Representative: Openshaw & Co.
(86) International application number: PCT/JP2021/036489
(87) International publication number: WO 2022/075229

(57) **Abstract**

A vacuum pump that is suitable to achieve uniformity of pressure in the chamber and improve the compression ratio, and a vacuum exhaust system using the vacuum pump. A vacuum pump includes: a cylindrical inner housing; a cylindrical stator placed outside the inner housing; a cylindrical shaft rotationally disposed between the inner housing and the stator; a motor configured to drive and rotate the shaft about an axis thereof; rotor blades in multiple stages disposed on an outer circumference surface of the shaft; and a cylindrical outer housing that is disposed outside the rotor blades in multiple stages and has an inlet port and an outlet port. A seal mechanism is provided in a gap between an outer circumference surface of the inner housing and an inner circumference surface of the shaft to inhibit an inflow of gas into the gap.

## Description

### TECHNICAL FIELD

The present invention relates to a vacuum pump used as a gas exhaust means for a process chamber or other chambers in a semiconductor manufacturing apparatus, a flat panel display manufacturing apparatus, or a solar panel manufacturing apparatus, and a vacuum exhaust system using the same, more particularly to those suitable to achieve uniformity of pressure in the chamber and improve the compression ratio.

### BACKGROUND ART

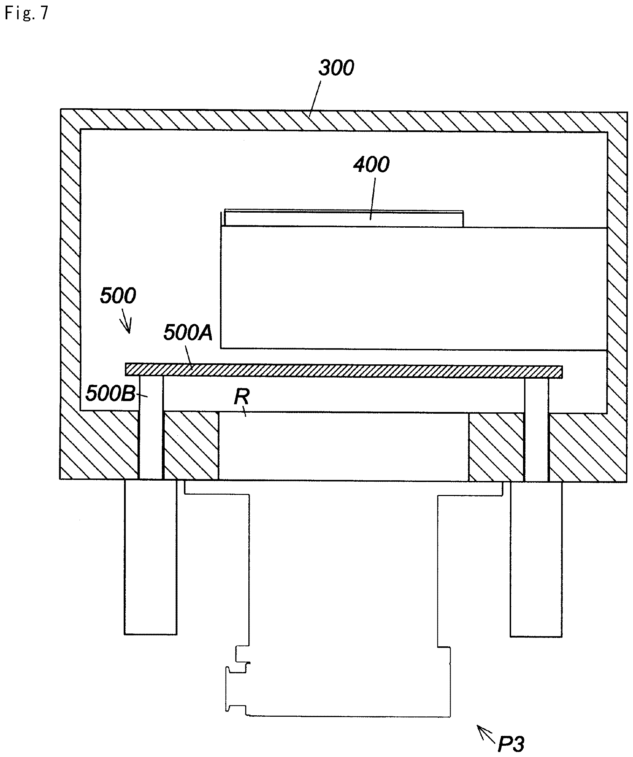

FIG. 7 is a cross-sectional view of a conventional vacuum exhaust system.

Referring to FIG. 7, in the conventional vacuum exhaust system, a vacuum pump P3 is connected to a chamber 300, and the gas in the chamber 300 is exhausted through the vacuum pump P3. A process stage 400 is provided in the chamber 300, and work such as a semiconductor wafer is placed on the process stage 400. Then, process gas is supplied into the chamber 300, and the work on the process stage 400 is processed by the process gas (for example, a semiconductor wafer etching process). The process gas used in the processing is exhausted out of the chamber 300 through the vacuum pump P3.

As a means for adjusting the pressure in the chamber 300 during processing with the process gas in the chamber 300 as described above, the conventional vacuum exhaust system of FIG. 7 has a gate valve device 500 in the chamber 300.

The gate valve device 500 has a valve main body 500A, which is placed in the chamber 300 and moves up and down to temporarily close and open a communication passage R connecting the vacuum pump P3 to the chamber 300. The up/down movement of the valve main body 500A is achieved by the ascending and descending action of a drive cylinder rod 500B.

However, in the conventional vacuum exhaust system of FIG. 7, the drive cylinder rod 500B for the up/down movement of the valve main body 500A is provided near the outer circumference of the communication passage R, and the process stage 400 is attached to the inner wall of the chamber 300. As such, the exhaust path lacks symmetry with respect to the process stage 400. This causes the gas to flow differently in the vicinity of the attachment portion and the other area, increasing the possibility of nonuniform pressure distribution. For example, during processing of work using the process gas, the flow of process gas may not be uniform near the process stage 400 or the drive cylinder rod 500B, making it difficult to maintain uniform pressure in the chamber 300 with the gate valve device 500. This leads to a problem where the processing of work using the process gas is uneven.

PTL 1 describes an exhaust system having a configuration in which a vacuum pump is placed coaxially with a process stage in a chamber, and a configuration in which this vacuum pump has a hollow structure having a hollow portion accommodating the process stage. Thus, this system is improved over the above-described conventional vacuum exhaust system of FIG. 7 in terms of how the process gas flows around the process stage.

However, in the exhaust system of PTL 1, the bearing of the rotor forming the vacuum pump provides communication between the suction side (upstream side) and the exhaust side (downstream side) of the vacuum pump. This causes problems where the desired compression ratio (the ratio of the pressure in the suction side and the pressure in the exhaust side, exhaust pressure/suction pressure) cannot be obtained due to an occurrence of gas backflow, and components of the magnetic bearing are corroded and damaged by corrosive gas.

### CITATION LIST

### PATENT LITERATURE

[PTL 1] Japanese Patent Application Publication No. 2000-183037

### SUMMARY OF INVENTION

### TECHNICAL PROBLEM

To solve the above problems, it is an object of the present invention to provide a vacuum pump that is suitable to achieve uniformity of pressure in a chamber and improve the compression ratio, and a vacuum exhaust system using the same.

### SOLUTION TO PROBLEM

In order to achieve the above object, a vacuum pump of the present invention includes a cylindrical inner housing; a cylindrical stator placed outside the inner housing; a cylindrical shaft rotationally disposed between the inner housing and the stator; a motor configured to drive and rotate the shaft about an axis thereof; rotor blades in multiple stages disposed on an outer circumference surface of the shaft; and a cylindrical outer housing that is disposed outside the rotor blades in multiple stages and has an inlet port and an outlet port, wherein a seal mechanism is provided in a gap between an outer circumference surface of the inner housing and an inner circumference surface of the shaft to inhibit an inflow of gas into the gap.

In the present invention, the seal mechanism may have different shapes or structures so as to function as a means for inhibiting an inflow of process gas into the gap in an upstream side of the gap and also to function as a means for inhibiting an inflow of purge gas into the gap in a downstream side of the gap.

In the present invention, the seal mechanism may include a plurality of blade portions on at least a part of the inner circumference surface of the shaft.

In the present invention, the seal mechanism may include a thread groove portion in at least a part of one of the outer circumference surface of the inner housing and the inner circumference surface of the shaft.

In the present invention, an inner circumference surface of the outer housing may be free of stator blades in multiple stages that are generally placed alternately with the rotor blades in multiple stages in an axial direction.

The present invention is also directed to a vacuum exhaust system including another vacuum pump that is coaxial with a central axis of the above-described vacuum pump and located downstream of the vacuum pump.

### ADVANTAGEOUS EFFECTS OF INVENTION

As described above, the present invention provides a vacuum pump and a vacuum exhaust system using the same. In the vacuum pump, both the inner housing and the outer housing are cylindrical, so that the entire vacuum pump has a hollow structure having a hollow portion accommodating a process stage in the chamber. This arrangement configuration of the process stage eliminates a factor that inhibits a flow of gas as with an attachment portion of a conventional process stage. Thus, the gas flows in a uniform manner around the process stage. In this respect, the present vacuum pump is suitable to achieve uniformity of pressure in the chamber.

As a specific configuration of the vacuum pump of the present invention, a configuration is adopted that includes the seal mechanism, which inhibits an inflow of gas into the gap between the outer circumference surface of the inner housing and the inner circumference surface of the shaft as described above. Thus, the seal mechanism blocks the communication between the exhaust side and the suction side via the gap. As such, a vacuum pump that can prevent backflow of gas from the exhaust side to the suction side through the gap and is suitable to improve the compression ratio, which is the ratio of the pressure in the suction side and the pressure in the exhaust side, and a vacuum exhaust system using the same are provided.

Additionally, the present invention can provide a reliable vacuum pump that is less likely to suffer a problem of corrosion and damage of the support system of the shaft (such as the electromagnets and sensors of the magnetic bearing), which would otherwise occur due to an inflow of corrosive gas into the gap described above, and has less troubles caused by failures of electronic components embedded in the pump, and an exhaust system using the same.

Furthermore, the present invention can provide a reliable vacuum exhaust system that has a configuration in which the function of achieving uniform pressure and the function for exhaust performance, such as the compression ratio, are appropriately allocated to different pumps, and thus achieves both uniform pressure and exhaust performance.

### BRIEF DESCRIPTION OF DRAWINGS

FIG. 1 is a cross-sectional view showing the configuration of a vacuum exhaust system to which the present invention is applied;
FIG. 2 is a cross-sectional view of a second vacuum pump that constitutes the vacuum exhaust system of FIG. 1;
FIG. 3 is a circuit diagram of an amplifier circuit;
FIG. 4 is a time chart showing control performed when a current command value is greater than a detected value;
FIG. 5 is a time chart showing control performed when a current command value is less than a detected value;
FIG. 6 is a diagram illustrating the concept of a seal mechanism; and
FIG. 7 is a cross-sectional view showing the configuration of a conventional vacuum exhaust system.

### DESCRIPTION OF EMBODIMENTS

The best mode for carrying out the present invention is described in detail below with reference to the accompanying drawings.

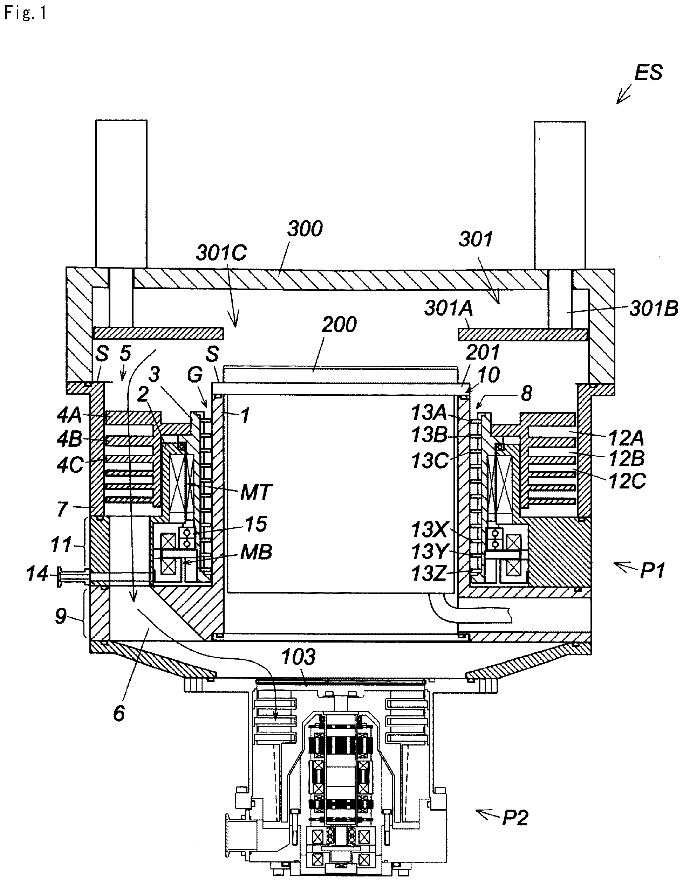

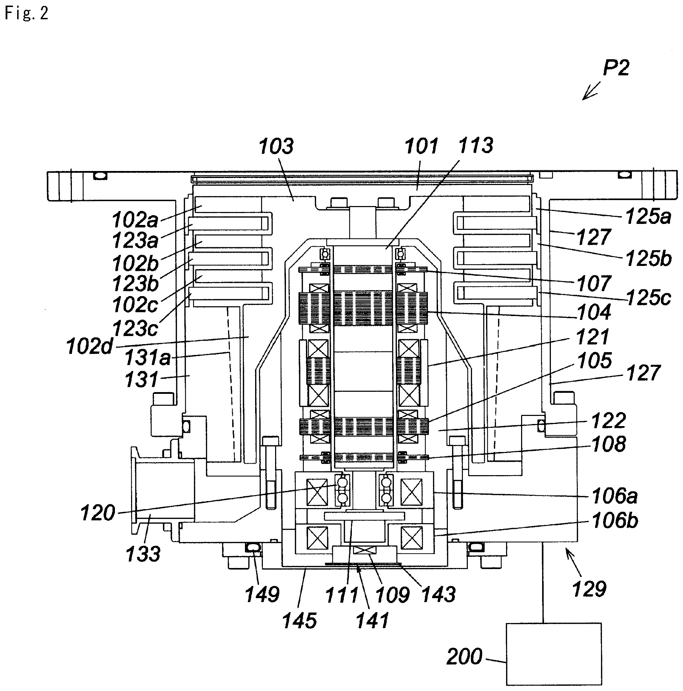

FIG. 1 is a cross-sectional view showing the configuration of a vacuum exhaust system to which the present invention is applied. FIG. 2 is a cross-sectional view of a second vacuum pump that constitutes the vacuum exhaust system of FIG. 1.

### Outline of Vacuum Exhaust System ES

FIG. 1 shows a vacuum exhaust system ES including a vacuum pump P1 (hereinafter referred to as "first vacuum pump") and a second vacuum pump P2 as another vacuum pump. The second vacuum pump P2 is coaxial with the central axis of the vacuum pump P1 and located downstream of the first vacuum pump P1.

### Details of Second Vacuum Pump P2

Referring to FIG. 2, the second vacuum pump P2 has an inlet port 101 formed at the upper end of a circular outer cylinder 127. A rotating body 103 in the outer cylinder 127 includes a plurality of rotor blades 102 (102a, 102b, 102c, ...), which are turbine blades for gas suction and exhaustion, in its outer circumference section. The rotor blades 102 extend radially in multiple stages. The rotating body 103 has a rotor shaft 113 in its center. The rotor shaft 113 is suspended in the air and position-controlled by a magnetic bearing of 5-axis control, for example.

As an example of a specific configuration of a magnetic bearing, upper radial electromagnets 104 include four electromagnets arranged in pairs on an X-axis and a Y-axis. Four upper radial sensors 107 are provided in close proximity to the upper radial electromagnets 104 and associated with the respective upper radial electromagnets 104. Each upper radial sensor 107 may be an inductance sensor or an eddy current sensor having a conduction winding, for example, and detects the position of the rotor shaft 113 based on a change in the inductance of the conduction winding, which changes according to the position of the rotor shaft 113. The upper radial sensors 107 are configured to detect a radial displacement of the rotor shaft 113, that is, the rotating body 103 fixed to the rotor shaft 113, and send it to the controller 200.

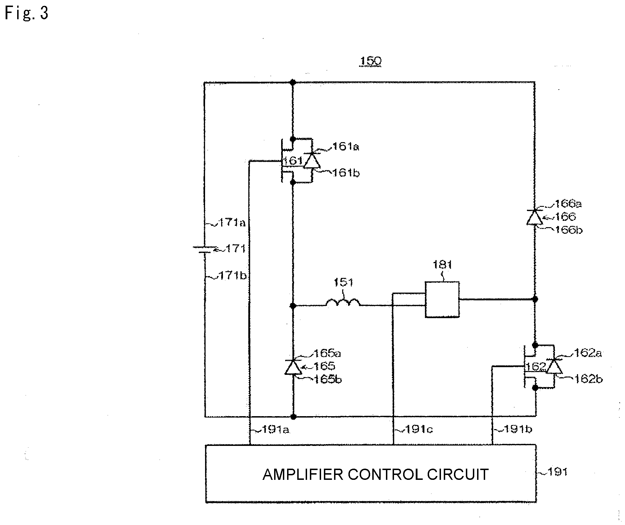

In the controller 200, for example, a compensation circuit having a PID adjustment function generates an excitation control command signal for the upper radial electromagnets 104 based on a position signal detected by the upper radial sensors 107. Based on this excitation control command signal, an amplifier circuit 150 (described below) shown in FIG. 3 controls and excites the upper radial electromagnets 104 to adjust a radial position of an upper part of the rotor shaft 113.

The rotor shaft 113 may be made of a high magnetic permeability material (such as iron and stainless steel) and is configured to be attracted by magnetic forces of the upper radial electromagnets 104. The adjustment is performed independently in the X-axis direction and the Y-axis direction. Lower radial electromagnets 105 and lower radial sensors 108 are arranged in a similar manner as the upper radial electromagnets 104 and the upper radial sensors 107 to adjust the radial position of the lower part of the rotor shaft 113 in a similar manner as the radial position of the upper part.

Additionally, axial electromagnets 106A and 106B are arranged so as to vertically sandwich a metal disc 111, which has a shape of a circular disc and is provided in the lower part of the rotor shaft 113. The metal disc 111 is made of a high magnetic permeability material such as iron. An axial sensor 109 is provided to detect an axial displacement of the rotor shaft 113 and send an axial position signal to the controller 200.

In the controller 200, the compensation circuit having the PID adjustment function may generate an excitation control command signal for each of the axial electromagnets 106A and 106B based on the signal on the axial position detected by the axial sensor 109. Based on these excitation control command signals, the amplifier circuit 150 controls and excites the axial electromagnets 106A and 106B separately so that the axial electromagnet 106A magnetically attracts the metal disc 111 upward and the axial electromagnet 106B attracts the metal disc 111 downward. The axial position of the rotor shaft 113 is thus adjusted.

As described above, the controller 200 appropriately adjusts the magnetic forces exerted by the axial electromagnets 106A and 106B on the metal disc 111, magnetically levitates the rotor shaft 113 in the axial direction, and suspends the rotor shaft 113 in the air in a non-contact manner. The amplifier circuit 150, which controls and excites the upper radial electromagnets 104, the lower radial electromagnets 105, and the axial electromagnets 106A and 106B, is described below.

The motor 121 includes a plurality of magnetic poles circumferentially arranged to surround the rotor shaft 113. Each magnetic pole is controlled by the controller 200 so as to drive and rotate the rotor shaft 113 via an electromagnetic force acting between the magnetic pole and the rotor shaft 113. The motor 121 also includes a rotational speed sensor (not shown), such as a Hall element, a resolver, or an encoder, and the rotational speed of the rotor shaft 113 is detected based on a detection signal of the rotational speed sensor.

Furthermore, a phase sensor (not shown) is attached adjacent to the lower radial sensors 108 to detect the phase of rotation of the rotor shaft 113. The controller 200 detects the position of the magnetic poles using both detection signals of the phase sensor and the rotational speed sensor.

A plurality of stator blades 123 (123a, 123b, 123c, ...) are arranged slightly spaced apart from the rotor blades 102 (102a, 102b, 102c, ...). Each rotor blade 102 (102a, 102b, 102c, ...) is inclined by a predetermined angle from a plane perpendicular to the axis of the rotor shaft 113 in order to transfer exhaust gas molecules downward through collision.

The stator blades 123 are also inclined by a predetermined angle from a plane perpendicular to the axis of the rotor shaft 113. The stator blades 123 extend inward of the outer cylinder 127 and alternate with the stages of the rotor blades 102. The outer circumference ends of the stator blades 123 are inserted between and thus supported by a plurality of layered stator blade spacers 125 (125a, 125b, 125c, ...).

The stator blade spacers 125 are ring-shaped members made of a metal, such as aluminum, iron, stainless steel, or copper, or an alloy containing these metals as components, for example. The outer cylinder 127 is fixed to the outer circumferences of the stator blade spacers 125 with a slight gap. A base portion 129 is located at the base of the outer cylinder 127. The base portion 129 has an outlet port 133 providing communication to the outside. The exhaust gas transferred to the base portion 129 through the inlet port 101 from the chamber is then sent to the outlet port 133.

According to the application of the second vacuum pump P2, a threaded spacer 131 may be provided between the lower part of the stator blade spacer 125 and the base portion 129. The threaded spacer 131 is a cylindrical member made of a metal such as aluminum, copper, stainless steel, or iron, or an alloy containing these metals as components. The threaded spacer 131 has a plurality of helical thread grooves 131a in its inner circumference surface. When exhaust gas molecules move in the rotation direction of the rotating body 103, these molecules are transferred toward the outlet port 133 in the direction of the helix of the thread grooves 131a. In the lowermost section of the rotating body 103 below the rotor blades 102 (102a, 102b, 102c, ...), a cylindrical portion 102d extends downward. The outer circumference surface of the cylindrical portion 102d is cylindrical and projects toward the inner circumference surface of the threaded spacer 131. The outer circumference surface is adjacent to but separated from the inner circumference surface of the threaded spacer 131 by a predetermined gap. The exhaust gas transferred to the thread grooves 131a by the rotor blades 102 and the stator blades 123 is guided by the thread grooves 131a to the base portion 129.

The base portion 129 is a disc-shaped member forming the base section of the second vacuum pump P2, and is generally made of a metal such as iron, aluminum, or stainless steel. The base portion 129 physically holds the second vacuum pump P2 and also serves as a heat conduction path. As such, the base portion 129 is preferably made of rigid metal with high thermal conductivity, such as iron, aluminum, or copper.

In this configuration, when the motor 121 drives and rotates the rotor blades 102 together with the rotor shaft 113, the interaction between the rotor blades 102 and the stator blades 123 causes the suction of exhaust gas from the chamber through the inlet port 101. The exhaust gas taken through the inlet port 101 moves between the rotor blades 102 and the stator blades 123 and is transferred to the base portion 129. At this time, factors such as the friction heat generated when the exhaust gas comes into contact with the rotor blades 102 and the conduction of heat generated by the motor 121 increase the temperature of the rotor blades 102. This heat is conducted to the stator blades 123 through radiation or conduction via gas molecules of the exhaust gas, for example.

The stator blade spacers 125 are joined to each other at the outer circumference portion and conduct the heat received by the stator blades 123 from the rotor blades 102, the friction heat generated when the exhaust gas comes into contact with the stator blades 123, and the like to the outside.

In the above description, the threaded spacer 131 is provided at the outer circumference of the cylindrical portion 102d of the rotating body 103, and the thread grooves 131a are engraved in the inner circumference surface of the threaded spacer 131. However, this may be inversed in some cases, and a thread groove may be engraved in the outer circumference surface of the cylindrical portion 102d, while a spacer having a cylindrical inner circumference surface may be arranged around the outer circumference surface.

According to the application of the second vacuum pump, to prevent the gas drawn through the inlet port 101 from entering an electrical portion, which includes the upper radial electromagnets 104, the upper radial sensors 107, the motor 121, the lower radial electromagnets 105, the lower radial sensors 108, the axial electromagnets 106A, 106B, and the axial sensor 109, the electrical portion may be surrounded by a stator column 122. The inside of the stator column 122 may be maintained at a predetermined pressure by purge gas.

In this case, the base portion 129 has a pipe (not shown) through which the purge gas is introduced. The introduced purge gas is sent to the outlet port 133 through gaps between a protective bearing 120 and the rotor shaft 113, between the rotor and the stator of the motor 121, and between the stator column 122 and the inner circumference cylindrical portion of the rotor blade 102.

The second vacuum pump P2 requires the identification of the model and control based on individually adjusted unique parameters (for example, various characteristics associated with the model). To store these control parameters, the second vacuum pump P2 includes an electronic circuit portion 141 in its main body. The electronic circuit portion 141 may include a semiconductor memory, such as an EEPROM, electronic components such as semiconductor elements for accessing the semiconductor memory, and a substrate 143 for mounting these components. The electronic circuit portion 141 is housed under a rotational speed sensor (not shown) near the center, for example, of the base portion 129, which forms the lower part of the second vacuum pump P2, and is closed by an airtight bottom lid 145.

Some process gas introduced into the chamber in the manufacturing process of semiconductors has the property of becoming solid when its pressure becomes higher than a predetermined value or its temperature becomes lower than a predetermined value. In the second vacuum pump P2, the pressure of the exhaust gas is lowest at the inlet port 101 and highest at the outlet port 133. When the pressure of the process gas increases beyond a predetermined value or its temperature decreases below a predetermined value while the process gas is being transferred from the inlet port 101 to the outlet port 133, the process gas is solidified and adheres and accumulates on the inner side of the second vacuum pump P2.

For example, when SiCl₄ is used as the process gas in an Al etching apparatus, according to the vapor pressure curve, a solid product (for example, AlCl₃) is deposited at a low vacuum (760 [torr] to 10⁻² [torr]) and a low temperature (about 20 [°C]) and adheres and accumulates on the inner side of the second vacuum pump P2. When the deposit of the process gas accumulates in the second vacuum pump P2, the accumulation may narrow the pump flow passage and degrade the performance of the second vacuum pump P2. The above-mentioned product tends to solidify and adhere in areas with higher pressures, such as the vicinity of the outlet port and the vicinity of the threaded spacer 131.

To solve this problem, conventionally, a heater or annular water-cooled tube 149 (not shown) is wound around the outer circumference of the base portion 129, and a temperature sensor (e.g., a thermistor, not shown) is embedded in the base portion 129, for example. The signal of this temperature sensor is used to perform control to maintain the temperature of the base portion 129 at a constant high temperature (preset temperature) by heating with the heater or cooling with the water-cooled tube 149 (hereinafter referred to as TMS (temperature management system)).

The amplifier circuit 150 is now described that controls and excites the upper radial electromagnets 104, the lower radial electromagnets 105, and the axial electromagnets 106A and 106B of the second vacuum pump P2 configured as described above. FIG. 3 is a circuit diagram of the amplifier circuit 150.

In FIG. 3, one end of an electromagnet winding 151 forming an upper radial electromagnet 104 or the like is connected to a positive electrode 171a of a power supply 171 via a transistor 161, and the other end is connected to a negative electrode 171b of the power supply 171 via a current detection circuit 181 and a transistor 162. Each transistor 161, 162 is a power MOSFET and has a structure in which a diode is connected between the source and the drain thereof.

In the transistor 161, a cathode terminal 161a of its diode is connected to the positive electrode 171a, and an anode terminal 161b is connected to one end of the electromagnet winding 151. In the transistor 162, a cathode terminal 162a of its diode is connected to a current detection circuit 181, and an anode terminal 162b is connected to the negative electrode 171b.

A diode 165 for current regeneration has a cathode terminal 165a connected to one end of the electromagnet winding 151 and an anode terminal 165b connected to the negative electrode 171b. Similarly, a diode 166 for current regeneration has a cathode terminal 166a connected to the positive electrode 171a and an anode terminal 166b connected to the other end of the electromagnet winding 151 via the current detection circuit 181. The current detection circuit 181 may include a Hall current sensor or an electric resistance element, for example.

The amplifier circuit 150 configured as described above corresponds to one electromagnet. Accordingly, when the magnetic bearing uses 5-axis control and has ten electromagnets 104, 105, 106A, and 106B in total, an identical amplifier circuit 150 is configured for each of the electromagnets. These ten amplifier circuits 150 are connected to the power supply 171 in parallel.

An amplifier control circuit 191 may be formed by a digital signal processor portion (not shown, hereinafter referred to as a DSP portion) of the controller 200. The amplifier control circuit 191 switches the transistors 161 and 162 between on and off.

The amplifier control circuit 191 is configured to compare a current value detected by the current detection circuit 181 (a signal reflecting this current value is referred to as a current detection signal 191c) with a predetermined current command value. The result of this comparison is used to determine the magnitude of the pulse width (pulse width time Tp1, Tp2) generated in a control cycle Ts, which is one cycle in PWM control. As a result, gate drive signals 191a and 191b having this pulse width are output from the amplifier control circuit 191 to gate terminals of the transistors 161 and 162.

Under certain circumstances such as when the rotational speed of the rotating body 103 reaches a resonance point during acceleration, or when a disturbance occurs during a constant speed operation, the rotating body 103 may require positional control at high speed and with a strong force. For this purpose, a high voltage of about 50 V, for example, is used for the power supply 171 to enable a rapid increase (or decrease) in the current flowing through the electromagnet winding 151. Additionally, a capacitor is generally connected between the positive electrode 171a and the negative electrode 171b of the power supply 171 to stabilize the power supply 171 (not shown).

In this configuration, when both transistors 161 and 162 are turned on, the current flowing through the electromagnet winding 151 (hereinafter referred to as an electromagnet current iL) increases, and when both are turned off, the electromagnet current iL decreases.

Also, when one of the transistors 161 and 162 is turned on and the other is turned off, a freewheeling current is maintained. Passing the freewheeling current through the amplifier circuit 150 in this manner reduces the hysteresis loss in the amplifier circuit 150, thereby limiting the power consumption of the entire circuit to a low level. Moreover, by controlling the transistors 161 and 162 as described above, high frequency noise, such as harmonics, generated in the second vacuum pump P2 can be reduced. Furthermore, by measuring this freewheeling current with the current detection circuit 181, the electromagnet current iL flowing through the electromagnet winding 151 can be detected.

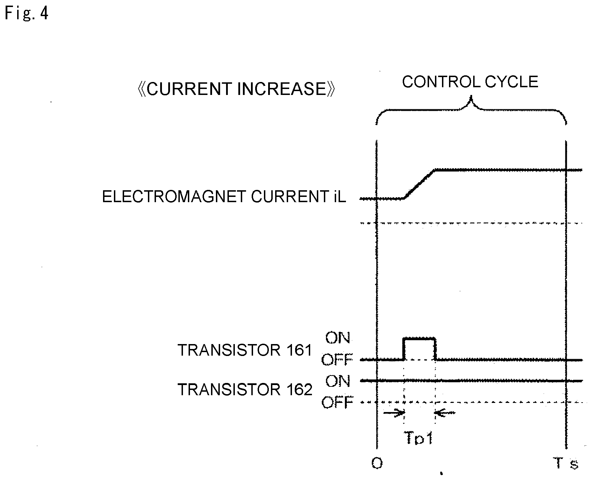

That is, when the detected current value is smaller than the current command value, as shown in FIG. 4, the transistors 161 and 162 are simultaneously on only once in the control cycle Ts (for example, 100 µs) for the time corresponding to the pulse width time Tp1. During this time, the electromagnet current iL increases accordingly toward the current value iLmax (not shown) that can be passed from the positive electrode 171a to the negative electrode 171b via the transistors 161 and 162.

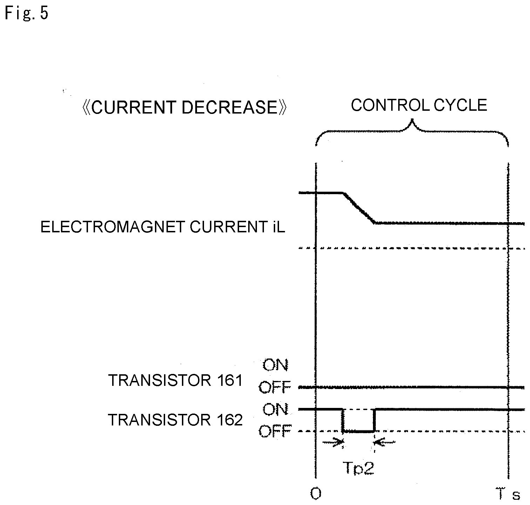

When the detected current value is larger than the current command value, as shown in FIG. 5, the transistors 161 and 162 are simultaneously off only once in the control cycle Ts for the time corresponding to the pulse width time Tp2. During this time, the electromagnet current iL decreases accordingly toward the current value iLmin (not shown) that can be regenerated from the negative electrode 171b to the positive electrode 171a via the diodes 165 and 166.

In either case, after the pulse width time Tp1, Tp2 has elapsed, one of the transistors 161 and 162 is on. During this period, the freewheeling current is thus maintained in the amplifier circuit 150.

### Overview of First Vacuum Pump P 1

Referring to FIG. 1, the first vacuum pump P1 includes a cylindrical inner housing 1, a cylindrical stator 2 arranged outside the inner housing 1, and a cylindrical shaft 3, which is rotationally arranged between the inner housing 1 and the stator 2, a motor MT, which drives and rotates the shaft 3 about its axis, rotor blades 4 (4A, 4B, 4C) in multiple stages disposed on the outer circumference surface of the shaft 3, and a cylindrical outer housing 7, which is provided outside the rotor blades 4 in multiple stages and has an inlet port 5 and an outlet port 6. A seal mechanism 8 is provided in a gap G between the outer circumference surface of the inner housing and the inner circumference surface of the shaft to inhibit an inflow of gas into the gap G.

### Details of Inner Housing 1

The first vacuum pump P1 has a configuration in which the inside of the inner housing 1 is a hollow portion accommodating a process stage 200. A flange portion 201 is formed on the outer circumference of the upper end portion of the process stage 200. The flange portion 201 abuts the upper end surface of the inner housing 1, and a fastening means (not shown), such as bolts, fastens the flange 201 to the inner housing 1. The inner housing 1 thus positions, fixes, and supports the process stage 200. A base portion 9 for supporting the entire first vacuum pump P1 is formed integrally with the lower portion of the inner housing 1.

A seal portion 10 is provided between the upper end surface of the inner housing 1 and the flange portion 201 at the outer circumference of the upper end portion of the process stage 200. The seal portion 10 blocks communication between the inside and outside of the inner housing 1. The outside of the inner housing 9 (specifically, the space between the inner housing 1 and the outer housing 7) is configured as vacuum region space communicating with a chamber 300 via the inlet port 5. The inside of the inner housing 1 is configured as atmospheric pressure region space. Of the entire process stage 200, a portion near its upper surface is in the vacuum region space (outside the inner housing 1), and the other portion is located in the atmospheric pressure region space (inside the inner housing 1).

### Details of Stator 2

Various electronic components such as magnetic bearings and motors (for example, the above-described electromagnets and sensors) are attached to the stator 2. Also, the stator 2 is coupled and fixed to the base portion 9 via a coupling portion 11 provided at the lower portion thereof. The stator 2 extends upright on the base portion 9.

As such, in the first vacuum pump P1, the lower end portion of the outer housing 7 is coupled and fixed to the coupling portion 11, and the coupling portion 11 is coupled and fixed to the base portion 9. The inner housing 1, the stator 2, and the outer housing 7 are thus integrated.

### Details of Shaft 3, Magnetic Bearing MB, and Motor MT

The shaft 3 is supported by a magnetic bearing MB and is thus disposed rotationally. The shaft 3 is also driven and rotated by the motor MT about its axis. The specific configuration of the magnetic bearing MB, such as that the shaft 3 is suspended in air and position-controlled by a 5-axis magnetic bearing, for example, is the same as the magnetic bearing of the second vacuum pump P2 described above. The detailed description thereof is thus omitted. Also, the specific configuration of this motor MT, such as that the motor MT includes a plurality of magnetic poles circumferentially arranged so as to surround the shaft 3, for example, is the same as that of the motor of the second vacuum pump P2 described above. The detailed description thereof is thus omitted. In FIG. 1, some components of the magnetic bearing MB and the motor MT are omitted.

The gap G between the shaft 3 and the inner housing 1 is necessary for the shaft 3 to rotate (hereinafter referred to as a "shaft radial gap G"). This shaft radial gap G is controlled to maintain a predetermined value using the magnetic bearing.

### Details of Rotor Blades 4 (4A, 4B, 4C, ...) and Others

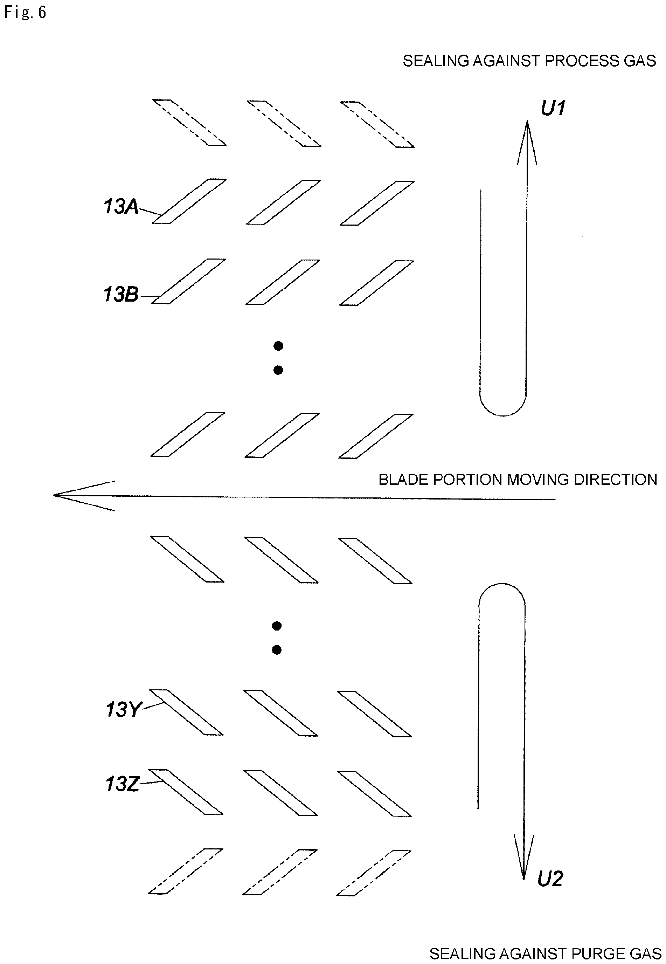

As described above, the first vacuum pump P1 has the rotor blades 4 in multiple stages on the outer circumference surface of the shaft 3 but does not have stator blades in multiple stages, which are generally placed alternately with the rotor blades 4 in multiple stages in the axial direction (see the stator blades 123 described for the second vacuum pump P2). That is, the areas around the rotor blades 4 (4A, 4B, 4C, ...) of the first vacuum pump P1 are set as stator blade absence portions 12 (12A, 12B, 12C, ...) where stator blades are not present. Nevertheless, a configuration may be adopted that includes such stator blades in multiple stages (see imaginary members indicated by dashed double-dotted lines in FIG. 6).

The configuration that includes the stator blade absence portions 12 (12A, 12B, 12C, ...) and does not have a plurality of stator blades 123 (123a, 123b, 123c, ...), which are generally provided as with the second vacuum pump P2, can be adopted because the first vacuum pump P1 prioritizes the uniformity of pressure in the chamber 300, and therefore a high compression ratio is not necessarily needed. A higher compression ratio would require a higher sealing effect of the seal mechanism 8 in the shaft radial gap G, which will be described below. Conversely, setting the sealing capability that can easily achieve the compression ratio required in this example allows the seal mechanism to be simplified.

### Details of Outer Housing 7

The upper end of the outer housing 7 opens as the inlet port 5 described above. The first vacuum pump P1 is coupled to the chamber 300 such that the inlet port 5 communicates with the bottom of the chamber 300.

The outlet port 6 described above is provided at the lower end of the outer housing 7. The first vacuum pump P1 is coupled to the second vacuum pump P2 such that the outlet port 6 communicate with the inlet port 101 of the second vacuum pump P2.

### Details of Chamber 300

A gate valve device 301 is provided in the chamber 300. As examples of specific structures of the gate valve device 301, the gate valve device 301 of the vacuum exhaust system ES of FIG. 1 has (1) a structure in which a valve main body 301A is placed inside the chamber 300, (2) a structure in which the ascending and descending action of a drive rod 301B, which extends from the ceiling surface of the chamber 300 toward the valve main body 301A allow the up/down movement of the valve main body 301A, (3) a structure in which an opening 301C, which corresponds in shape to the upper end portion of the process stage 200, is provided in the valve main body 301A, and a descending movement of the valve main body 301A causes the upper end portion of the process stage 200 to fit into the opening 301C, and (4) a structure in which, when the fit is achieved, the step surface at the outer circumference of the process stage 200 and a section near the inner side of the upper end surface of the outer housing 7 serve as seal surfaces S, and the lower surface of the valve main body 301A abuts the seal surface S to block the communication between the chamber 300 and the first vacuum pump P1 via the inlet port 5.

### Overview of Seal Mechanism

The seal mechanism 8 has different shapes or structures so as to function as a means for inhibiting an inflow of process gas into the shaft radial gap G in the upstream side of the gap G as indicated by arrow U1 in FIG. 6, and to function as a means for inhibiting an inflow of purge gas into the gap G in the downstream side of the gap G as indicated by arrow U2 in FIG. 6.

### Example of Seal Mechanism (1)

As an example for specifically achieving the function of the above-mentioned seal mechanism 8 (the function of inhibiting an inflow into the gap G), the first vacuum pump P1 has a configuration in which the seal mechanism 8 includes a plurality of blade portions 13 (13A, 13B, 13C, ..., 13Z) on at least a part of the inner circumference surface of the shaft 3, and the blade portions 13 in the upstream side of the shaft radial gap G and the blade portions 13 in the downstream side are inclined in different directions.

Specifically, the blade portions 13 (13A, 13B, etc.) in the upstream side of the shaft radial gap G are inclined in a direction that causes the gas molecules flowing toward the inside of the gap G from the inlet port 5 to bounce off (see U-shaped arrow U1 in FIG. 6) the blade portions 13. In contrast, the blade portions 13 (13Y, 13Z, etc.) in the downstream side of the shaft radial gap G are inclined in a direction that causes the gas molecules flowing toward the inside of the gap G from the outlet port 6 to bounce off (see U-shaped arrow U2 in FIG. 6) the blade portions 13.

When the moving direction of the blade portions is defined as the inclination reference (0°) of the blade portions, the inclination angle θ1 of the blade portions 13 (13A, 13B, etc.) in the upstream side of the shaft radial gap G may be set within the range of 0° < θ1 < 90° as appropriate. The inclination angle θ2 of the blade portions 13 (13Y, 13Z, etc.) in the downstream side of the shaft radial gap G may be set within the range of -90° < θ2 < 0° as appropriate.

Also, when multiple blade portions 13 are present in the upstream side of the shaft radial gap G as shown in FIG. 1, the inclination angles θ1 of the blade portions 13 (13A, 13B, etc.) do not have to be the same and may be different as long as they are in the range of 0° < θ1 < 90°. This also applies when multiple blade portions 13 (13Y, 13Z, etc.) are present in the downstream side of the shaft radial gap G.

In the first vacuum pump P1, the blade portions 13 (13A, 13B, 13C) are supported with their outer circumference edges inserted between a plurality of stacked spacers (reference numerals omitted). However, the blade portions 13 may be supported in a different manner.

When the operation start button (not shown) of the first vacuum pump P1 is pressed, the shaft 3 rotates about its axis, and the rotor blades 4 (4A, 4B, 4C, ...) and the blade portions (13A, 13B, 13C, ...) of the seal mechanism 8 rotate integrally with the shaft 3. The rotating action of the rotor blades 4 moves the process gas molecules in the chamber 300 from the inlet port 5 toward the outlet port 6 to be exhausted.

At this time, some of the process gas molecules flow toward the inside of the upstream side of the shaft radial gap G from the inlet port 5, but the seal mechanism 8 blocks such an inflow. This results from the action of the blade portions 13 (13A, 13B, etc.) rotating in the upstream side of the shaft radial gap G and causing the gas molecules to bounce off.

In the first vacuum pump P1, for the purpose of cooling the internal components such as the shaft 3 and the stator 2 and protecting against corrosive gas, purge gas, such as nitrogen gas, may be continuously supplied into the first vacuum pump P1 from a purge gas supply port 14 provided in the coupling portion 11.

The purge gas thus supplied flows between the inner and outer rings of a protective bearing 15, through the gap between the stator 2 and the shaft 3, and through the gap between the stator 2 and the base of the rotor blades 4 (4A, 4B, 4C, ...) in this order, and then returns in the direction of the purge gas supply port 14.

At this time, part of the purge gas flows toward the inside of the downstream side of the shaft radial gap G, but the seal mechanism 8 blocks such an inflow. This results from the action of the blade portions 13 (13Z, 13Y, etc.) rotating in the downstream side of the shaft radial gap G and causing gas molecules to bounce off.

### Example of Seal Mechanism (2)

Although not shown, as another example for specifically achieving the function of the seal mechanism 8 (the function of inhibiting an inflow into the gap G), a configuration may be adopted in which the seal mechanism 8 has a thread groove portion at least in a portion of one of the outer circumference surface of the inner housing 1 or the inner circumference surface of the shaft 3, and the spirals of the thread groove portion in the upstream side and in the downstream side in the shaft radial gap G wind in different directions.

In this case, it may be configured such that the shape of the thread groove portion in the upstream side of the shaft radial gap G has a thread groove shape of a right-hand thread, while the shape of the thread groove portion in the downstream side of the shaft radial gap G has a thread groove shape of a left-hand thread, but the configuration is not limited to this.

That is, any configuration may be used as long as the thread groove portion in the upstream side of the shaft radial gap G has a thread groove shape that can cause the gas molecules flowing toward the inside of the gap G from the inlet port 5 to bounce off, and the thread groove portion in the downstream side of the shaft radial gap G has a thread groove shape that can cause the gas molecules flowing toward the inside of the gap G from the outlet port 6 to bounce off.

As described above, in the first vacuum pump P1 of the embodiment described above, both the inner housing 1 and the outer housing 7 are cylindrical, so that the entire vacuum pump P1 has a hollow structure having a hollow portion accommodating the process stage 200 in the chamber 300. This arrangement configuration of the process stage 200 eliminates a factor that inhibits a flow of gas as with an attachment portion of a conventional process stage. Thus, the gas flows in a uniform manner around the process stage 200. This is advantageous in obtaining uniformity of pressure in the chamber 300.

As a specific configuration of the vacuum pump P1, a configuration is adopted that includes the seal mechanism 8 in the radial gap G (gap G) between the outer circumference surface of the inner housing 1 and the inner circumference surface of the shaft 3 to inhibit an inflow of gas into the radial gap G. Thus, the seal mechanism 8 blocks the communication between the exhaust side and the suction side via the radial gap G, preventing backflow of gas through the gap G.

Additionally, the present invention can provide a reliable vacuum pump that is less likely to suffer a problem of corrosion and damage of the support system of the shaft (such as the electromagnets and sensors of the magnetic bearing), which would otherwise occur due to an inflow of corrosive gas into the gap described above, and has fewer troubles caused by failures of electronic components embedded in the pump, and an exhaust system using the same.

Moreover, with the present invention, the second vacuum pump P2 is coaxial with the central axis of the first vacuum pump P1 and located downstream of the first vacuum pump P1. This configuration can achieve the exhaust performance, including the compression ratio, that is needed for a vacuum exhaust system but cannot be easily achieved by the first vacuum pump P1 alone. As such, the present invention can provide a reliable exhaust system that achieves both the uniformity of the pressure and the exhaust performance.

It should be noted that the present invention is not limited to the above-described embodiments, and various modifications can be made by the ordinary creative ability of those skilled in the art within the scope of the technical idea of the present invention.

### REFERENCE SIGNS LIST

- 1: Inner housing
- 2: Stator
- 3: Shaft
- 4A, 4B, 4C: Rotor blade
- 5: Inlet port
- 6: Outlet port
- 7: Outer housing
- 8: Seal mechanism
- 9: Base portion
- 10: Seal portion
- 11: Coupling portion
- 12: Stator blade absence portion
- 13: Blade portion
- 14: Purge gas supply port
- 15: Protective bearing
- 200: Process stage
- 300: Chamber
- 301: Gate valve device
- 301A: Valve main body
- G: Gap (shaft radial gap)
- MT: Motor
- MB: Magnetic bearing

## Claims

1. A vacuum pump comprising:
a cylindrical inner housing;
a cylindrical stator placed outside the inner housing;
a cylindrical shaft rotationally disposed between the inner housing and the stator;
a motor configured to drive and rotate the shaft about an axis thereof;
rotor blades in multiple stages disposed on an outer circumference surface of the shaft; and
a cylindrical outer housing that is disposed outside the rotor blades in multiple stages and has an inlet port and an outlet port,
wherein a seal mechanism is provided in a gap between an outer circumference surface of the inner housing and an inner circumference surface of the shaft to inhibit an inflow of gas into the gap.

2. The vacuum pump according to claim 1, wherein the seal mechanism has different shapes or structures so as to function as a means for inhibiting an inflow of process gas into the gap in an upstream side of the gap and also to function as a means for inhibiting an inflow of purge gas into the gap in a downstream side of the gap.

3. The vacuum pump according to claim 1 or 2, wherein the seal mechanism includes a plurality of blade portions on at least a part of the inner circumference surface of the shaft.

4. The vacuum pump according to any one of claims 1 to 3, wherein the seal mechanism includes a thread groove portion in at least a part of one of the outer circumference surface of the inner housing and the inner circumference surface of the shaft.

5. The vacuum pump according to any one of claims 1 to 4, wherein an inner circumference surface of the outer housing is free of stator blades in multiple stages that are generally placed alternately with the rotor blades in multiple stages in an axial direction.

6. A vacuum exhaust system comprising another vacuum pump that is coaxial with a central axis of the vacuum pump according to claim 1 and located downstream of the vacuum pump.
